**Europäisches Patentamt**

**European Patent Office**

**Office européen des brevets**

(19)

(11) Veröffentlichungsnummer: **0 113 073**

**A1**

(12) # EUROPÄISCHE PATENTANMELDUNG

(21) Anmeldenummer: **83112229.6**

(22) Anmeldetag: **06.12.83**

(51) Int. Cl.³: **H 05 K 5/06**

(30) Priorität: **31.12.82 DE 3248715**

(43) Veröffentlichungstag der Anmeldung:
**11.07.84 Patentblatt 84/28**

(84) Benannte Vertragsstaaten:
**DE FR GB IT**

(71) Anmelder: **ROBERT BOSCH GMBH**
**Postfach 50**
**D-7000 Stuttgart 1(DE)**

(72) Erfinder: **Goebel, Ulrich, Dr. Dipl.-Phys.**
**Justinus-Kerner-Strasse 129**
**D-7410 Reutlingen(DE)**

(72) Erfinder: **Schmidt, Lothar, Dr. Dipl.-Phys.**
**Schiesshausstrasse 15 B**
**D-7000 Stuttgart 70(DE)**

(54) **Elektrisches Schaltgerät, insbesondere für Kraftfahrzeuge.**

(57) Es wird ein elektrisches Schaltgerät, insbesondere für Kraftfahrzeuge vorgeschlagen, das zum Steuern und/oder Regeln von beispielsweise Zündanlagen, Benzineinspritzung, Antiblockiersystemen, Getriebesteuerungen dient. Das elektrische Schaltgerät hat ein feuchtigkeitsdichtes Gehäuse (1); dessen eine elektrische Schaltung (4; 5) aufnehmender Gehäuseteil (2) ist von einer feuchtigkeitsdichten, flexiblen Membran (6) abgeschlossen, während ein zwischen Membran (6) und Deckel (9) des Schaltgeräts gebildeter Gehäuseteil (10) belüftet ist. Durch die Membran (6) ist der Schutz der Schaltung (4; 5) gegen Feuchtigkeit gewährleistet, während der Deckel (9) den mechanischen Schutz der Membran (6) sichert. Zudem wird durch die Membran der Druckausgleich bei Temperatur-änderungen und/oder Änderungen des Außendrucks durch Volumenanpassung im Gehäuse ermöglicht. Dadurch ist die sichere Funktion des Schaltgeräts beim rauhen Betrieb in Kraftfahrzeugen auch beim Anbau im Motorraum ermöglicht.

FIG. 1

EP 0 113 073 A1

22.12.1982 Wo/Kc

ROBERT BOSCH GMBH, 7000 Stuttgart 1

Elektrisches Schaltgerät, insbesondere für Kraftfahrzeuge

Stand der Technik

Die Erfindung geht von einem elektrischen Schaltgerät
nach der Gattung des Hauptanspruchs aus. Es ist schon ein
elektrisches Schaltgerät bekannt, bei dem das starre Gehäuse in aufwendiger Weise dicht ausgebildet ist, um
Über- und Unterdruck im Gehäuseinnern gegenüber dem
Außendruck standzuhalten. Dabei ist von Nachteil, daß
auch bei "dichten" Gehäusen keine 100 %ige Dichtheit
gewährleistet werden kann, weil Wasser bei Unterdruck
durch kleinste Kapillaren in den die elektrischen Schaltelemente und Verbindungsmittel enthaltenden Raum hineingedrückt wird und zu stauender Nässe im Gehäuse führt.
Weiterhin ist bekannt, elektrische Schaltgeräte zu belüften. Bei diesen Schaltgeräten ist jedoch von Nachteil, daß die einzelnen elektrischen Schaltelemente
einzeln gegen Feuchtigkeit geschützt werden müssen.
Beide bekannte Arten von Schaltgeräten sind daher für

...

die Anforderungen beim rauhen Betrieb in Kraftfahrzeugen
nur mit aufwendigen Mitteln in teuren Verfahren herstellbar, was bei Großmengenfertigung nunmehr zu unwirtschaftlich geworden ist.

Vorteile der Erfindung

Das erfindungsgemäße elektrische Schaltgerät mit den kennzeichnenden Merkmalen des Hauptanspruchs hat demgegenüber
den Vorteil, daß durch Trennen der Funktionen "Schutz
gegen Feuchtigkeit" und "mechanischer Schutz" der aus elektrischen Schaltelementen, Verbindungsmitteln und Steckeranschlüssen· bestehenden Schaltung mit einfachen Mitteln
die Nachteile der bekannten Schaltgeräte vermieden werden. Als weiterer Vorteil ist anzusehen, daß durch die
Trennmittel Druckausgleich bei Temperatur- und/oder Druckänderungen durch Volumenanpassung im Schaltgerät möglich
ist.

Durch die in den Unteransprüchen aufgeführten Maßnahmen
sind vorteilhafte Weiterbildungen des im Hauptanspruch
angegebenen Schaltgeräts möglich. Besonders vorteilhaft
ist, die in dem Gehäuse aufgenommene Schaltung zu vergießen und als Trennmittel eine feuchtigkeitsdichte,
flexible Membran im Schaltgerät anzuordnen, die direkt
an der Gießmasse anliegt oder mit Abstand zur Gießmasse den die Schaltung aufnehmenden Gehäuseteil abschließt, während der Deckel als mechanischer Schutz
der Schaltung samt Trennmittel einen belüfteten Gehäuseteil umschließt.

...

Zeichnung

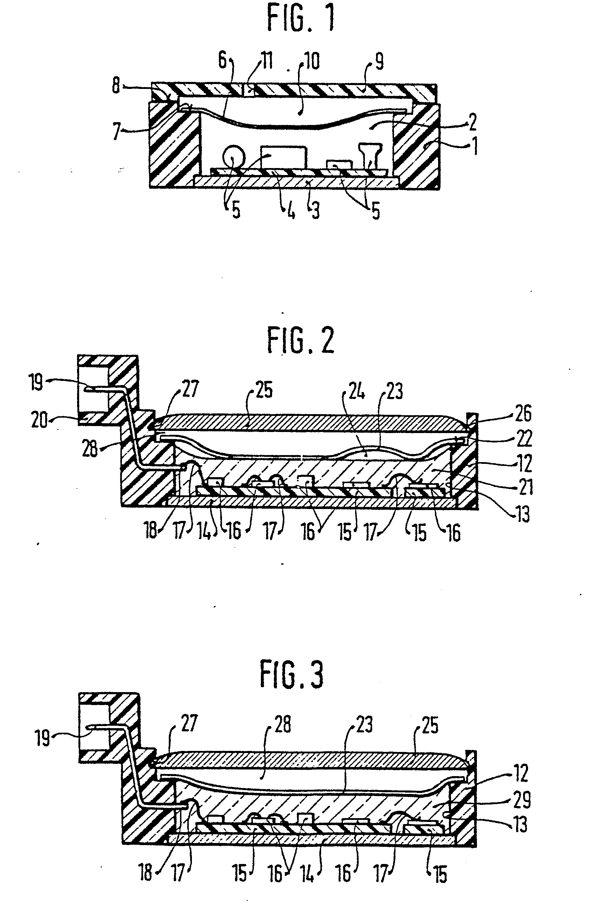

Ausführungsbeispiele der Erfindung sind in der Zeichnung
dargestellt. Es zeigen Figur 1 ein erstes Ausführungsbeispiel eines elektrischen Schaltgeräts im Querschnitt,
Figur 2 ein zweites Ausführungsbeispiel des elektrischen
Schaltgeräts im Längsschnitt und Figur 3 eine Abwandlung
des Schaltgeräts nach Figur 2.

Beschreibung der Ausführungsbeispiele

Ein erfindungsgemäßes elektrisches Schaltgerät ist beispielsweise geeignet für Zündanlagen, Benzineinspritzungen,
Antiblockiersysteme, Getriebesteuerungen in Kraftfahrzeugen. Sein Gehäuse und die Anordnung der Schaltung
gewährleistet eine sichere Funktion des Schaltgeräts
bei dem rauhen Betrieb in Kraftfahrzeugen, auch wenn es
im Motorraum eingebaut ist.

Ein erstes Ausführungsbeispiel des Schaltgerätes hat ein
Gehäuse 1 mit einem feuchtigkeitsdichten vertieften Gehäuseteil 2. Das Gehäuse 1 ist als Spritzteil aus feuchtigkeitsundurchlässsigem isolierendem Kunststoff gebildet,
das um den Rand einer Grundplatte 3 aus Metall greift. Die
Grundplatte 3 trägt einen beispielsweise als Leiterplatte
ausgebildeten Aufnahmekörper 4 für elektrische Schaltelemente 5, welche in an sich bekannter und nicht näher
dargestellter Weise an Verbindungsmittel wie Leiterbahnen angeschlossen sind. Der Gehäuseteil 2 ist von
einer feuchtigkeitsundurchlässigen, flexiblen Membran
6 feuchtigkeitsdicht abgeschlossen. Das Gehäuse 1 hat
eine Innenschulter 7 auf der der Rand der Membran 6
beispielsweise durch Verschweißen mittels Wärme oder

...

Reiben, durch Verkleben, durch Einklemmen oder durch Adhäsion befestigt ist. An der Stirnseite 8 des Gehäuses 1 ist ein Deckel 9 angeordnet und in an sich bekannter und nicht näher dargestellten Weise befestigt. Zwischen der Membran 6 und dem Deckel 9 ist ein Gehäuseteil 10 gebildet, der beispielsweise durch eine Bohrung 11 im Deckel 9 belüftet ist.

Durch die Membran 6 ist der die Schaltung 4, 5 aufnehmende Gehäuseteil 2 feuchtigkeitsdicht abgeschlossen. Desgleichen gleicht die Membran 6 durch Temperaturänderungen und/oder Änderungen des Außendrucks hervorgerufene Druckänderungen im Gehäuseteil 2 dadurch aus, daß sie ihre Lage und somit das Volumen des Gehäuseteils 2 entsprechend ändert, bis Druckgleichheit beiderseits der Membran 6 herrscht. Der Deckel 9 dagegen ermöglicht die Belüftung des Gehäuseteils 10 und schützt die Membran 6 vor mechanischen Einflüssen.

Ein zweites Ausführungsbeispiel des Schaltgerätes nach Figur 2 hat wiederum ein Gehäuse 12 mit einem feuchtigkeitsdichten vertieften Gehäuseteil 13. Das Gehäuse 12 ist ebenfalls aus feuchtigkeitsundurchlässsigem isolierendem Kunststoff gebildet, das um den Rand einer Grundplatte 14 aus Metall greift. Die Grundplatte 14 trägt Aufnahmekörper 15, von denen zwei dargestellt sind. Sie sind z. B. als Keramikplatten ausgebildet, auf denen elektrische Schaltelemente 16 sitzen, die durch Verbindungsteile 17 mit an sich bekannten und nicht näher dargestellten zugeordneten Leiterbahnen oder Steckeranschlüssen 18 von Steckern 19 verbunden sind. Die Stecker 19 sind bereits beim Herstellen des Gehäuses 12 in das Gehäuse 12 feuchtigkeitsdicht integriert. Sie ragen aus dem Gehäuse

...

12 im Bereich einer außen an das Gehäuse 12 angeformten
Aufnahme 20 für einen ebenfalls an sich bekannten und
nicht näher dargestellten Gegenstecker einer Zuleitung
zu einem zu schaltenden Aggregat des Kraftfahrzeugs.

Das vertiefte Gehäuseteil 13 ist nahezu völlig mit einer
Gießmasse 21, beispielsweise Silikonverguß ausgefüllt,
so daß sämtliche Schaltelemente 16 und Verbindungsmittel
17; 18 in die Gießmasse 21 eingebettet sind. Das Gehäuse
12 hat auch eine Innenschulter 22, auf der wiederum der
Rand einer feuchtigkeitsdichten, flexiblen Membran 23'
befestigt ist wie bereits zum ersten Ausführungsbeispiel
nach Figur 1 beschrieben. Zwischen der Oberfläche der
Gießmasse 21 und der Membran 23 ist ebenfalls ein Luftraum 24 gebildet.

Das Gehäuse 12 ist mit einem Deckel 25 verschlossen.
Der Deckel 25 ist in eine umlaufende Nut 26 an der
Innenwand des Gehäuses 12 eingerastet. Er ist mit mindestens einer nicht dargestellten Bohrung oder mit Ausnehmungen 27 an seinem Rand versehen, durch welche
der sich zwischen der Membran 23 und dem Deckel 25 erstreckende Gehäuseteil 28 belüftet ist.

Zusätzlich zu dem Schaltgerät nach Figur 1 ist bei dem
Ausführungsbeispiel nach Figur 2 die elektrische Schaltung
15 bis 18 durch die Gießmasse 21 gesichert. Die Vergußmasse dient beispielsweise als redundanter Schutz vor Migration und Korrosion an spannungsführenden Teilen. Sie
erhöht die Spannungsfestigkeit und schützt vor beweglichen
Fremdkörpern wie Lotbröckchen oder Abrieb von Gehäuseteilen.

Bei dem abgewandelten Schaltgerät nach Figur 3 sind die
Teile gleich denen des Schaltgeräts nach Figur 2 mit
denselben Bezugszahlen bezeichnet.

...

Das Schaltgerät hat wiederum die im vertieften Gehäuseteil 13 angeordnete Schaltung 15 bis 18, die in eine Gießmasse 29, beispielsweise Silikonverguß eingebettet ist. Die Gießmasse 29 füllt den Gehäuseteil 13 soweit, daß die Membran 23 ohne Zwischenraum an der Gießmasse 29 anliegt. Dadurch ist ein Druckausgleich bei nur geringer Membranbewegung möglich.

R. 18295

0113073

22.12.1982 Wo/Kc

ROBERT BOSCH GMBH, 7000 Stuttgart 1

Ansprüche

1. Elektrisches Schaltgerät, insbesondere für Kraftfahrzeuge, mit einem Gehäuse, in dem mindestens ein Verbindungsmittel und elektrische Schaltelemente tragender Aufnahmekörper angeordnet ist, aus dem mit zugehörigen Verbindungsmitteln verbundene Stecker abgedichtet herausragen, und das mit einem Deckel verschlossen ist, dadurch gekennzeichnet, daß ein den Aufnahmekörper (4; 15) mit sämtlichen Schaltelementen (5; 16, 17) und Steckeranschlüssen (18) aufnehmender Gehäuseteil (2; 13) mit einer Membran (6; 23) abgeschlossen ist, und ein anderer Gehäuseteil (10, 28) zwischen Membran (6; 23) und Deckel (9; 25) belüftbar ist.

2. Schaltgerät nach Anspruch 1, dadurch gekennzeichnet, daß der den Aufnahmekörper (15) mit sämtlichen Schaltelementen (16, 17) und Steckeranschlüssen (18) aufnehmende Gehäuseteil (13) mit einer Gießmasse (21) gefüllt ist.

...

3. Schaltgerät nach Anspruch 2, dadurch gekennzeichnet, daß die Gießmasse (29) bis an die den Gehäuseteil (13) abschließende Membran (23) reicht.

4. Schaltgerät nach Anspruch 2, dadurch gekennzeichnet, daß im Gehäuseteil (13) zwischen der Oberfläche der sämtliche Schaltelemente (16, 17) und Anschlüsse (18) einschließenden Gießmasse (21) und der den Gehäuseteil (13) abschließenden Membran (23) ein Luftraum (24) eingeschlossen ist.

5. Schaltgerät nach einem der Ansprüche 1 bis 4, dadurch gekennzeichnet, daß die den Aufnahmekörper (4; 15), Bauelemente (5; 16, 17) und Steckeranschlüsse (18) aufnehmenden Gehäuseteil (2; 13) abschließende Membran (6; 23) flexibel und/oder elastisch sowie feuchtigkeitsdicht ist.

## FIG. 1

## FIG. 2

## FIG.3

Europäisches
Patentamt

EUROPÄISCHER RECHERCHENBERICHT

0113073
Nummer der Anmeldung

EP 83 11 2229

## EINSCHLÄGIGE DOKUMENTE

| Kategorie | Kennzeichnung des Dokuments mit Angabe. soweit erforderlich, der maßgeblichen Teile | Betrifft Anspruch | KLASSIFIKATION DER ANMELDUNG (Int. Cl. 3) |
|---|---|---|---|
| X | EP-A-0 028 547 (THOMSON) <br> * Ansprüche; Figuren 2,3 * <br><br> --- | 1,5 | H 05 K 5/06 |
| A | DE-A-3 107 694 (WEINLICH) <br> * Ansprüche; Figuren 1,2 * <br><br> --- | 1,5 | |
| A | ELEKTRONIK, Band 28, Nr. 2, Januar 1979, Seiten 39-41, Franzis-Verlag, München, DE <br> R. PAQUET: "Einbettung von Baugruppen in Silikon-Elastomere" <br> * Seite 39, Kapitel 1,2 * <br><br> ----- | 2 | |

RECHERCHIERTE
SACHGEBIETE (Int. Cl. 3)

H 01 H 9/00
H 05 K 5/00

Der vorliegende Recherchenbericht wurde für alle Patentansprüche erstellt.

| Recherchenort <br> DEN HAAG | Abschlußdatum der Recherche <br> 26-03-1984 | Prüfer <br> TOUSSAINT F.M.A. |
|---|---|---|